# EUROPEAN PATENT SPECIFICATION

(11) **EP 3 069 587 B1**
(45) Date of publication and mention of the grant of the patent: **07.11.2018**
(21) Application number: 14815032.9
(22) Date of filing: 14.11.2014
(51) Int. Cl.: H05K 7/20, G06F 1/20

(54) **MODULAR SUPER-CALCULATION ARCHITECTURE**
MODULARE SUPERRECHNERARCHITEKTUR
ARCHITECTURE DE SUPERCALCUL MODULAIRE

(30) Priority: 15.11.2013 IT UD20130151
(43) Date of publication of application: 21.09.2016
(73) Proprietor: Eurotech SPA, 33020 Amaro (IT)
(72) Inventor: ROSSI, Mauro, I-33013 Gemona del Friuli (IT); PLEITER, Dirk, 10961 Berlino (DE); ARTS, Paulus Petrus Bernardus, I-33013 Gemona del Friuli (IT); TECCHIOLLI, Giampietro, I-38123 Trento (IT); WETTIG, Tilo, 93055 Regensburg (DE)
(74) Representative: Petraz, Gilberto Luigi
(86) International application number: PCT/IB2014/066047
(87) International publication number: WO 2015/075611

(56) References cited:
- US-A1- 2006 002 080
- US-A1- 2006 065 874
- US-A1- 2009 260 777
- US-A1- 2013 194 745

## Description

### FIELD OF THE INVENTION

The present invention concerns a modular super-calculation architecture.

### BACKGROUND OF THE INVENTION

It is known to make modular super-calculation architectures, liquid coolable, such as for example as described in WO-A-2012/014058 or WO-A-2012/066414 or WO-A-2013/050813.

Known modular super-calculation architectures can have limits or disadvantages in terms of maintenance, installation and/or repairs, with the risk of negatively affecting and reducing the activity time of such architectures, also known as "uptime". This translates into unwanted costs which must be minimized. The limit is even greater in liquid cooled architectures, as problems of management, reliability and safety of the hydraulic circuit of the cooling liquid are involved.

Known solutions that try to keep a minimum degree of usability in possible operating conditions of the system provide computation modules, also called node cards, provided with cooling plates and interconnection with rear connection planes (so-called "blade" configuration), such as for example in application US-A-2006/065874. However, in any case there are problems of wear, stresses and mechanical traction, especially in conditions of installation, maintenance or repairs to said blades, with a consequent risk of spillage of liquid, unstable electric connections and, ultimately, reduction in the available calculation capacity in the best of cases, which is a crucial question in the super-calculation architectures in question.

There is therefore a need to perfect a module super-calculation architecture that can overcome at least one of the disadvantages of the state of the art.

In particular, one purpose of the present invention is to obtain a modular super-calculation architecture which is easily scalable, easily managed and which allows to intervene, in the event of maintenance, installation and/or repairs, easily and quickly, in particular also in the case of liquid cooling, without penalizing the computation performance of the system.

Another purpose is to obtain a modular super-calculation architecture whose individual electronic calculation modules can be used independently of the presence of other modules in the system.

Another purpose of the present invention is to obtain a super-calculation architecture that allows to obtain the purposes described above, also using electronic cards inside the electronic calculation module with adequate standards established to guarantee inter-functionality between compatible commercial electronic cards (standard form factor).

The Applicant has devised, tested and embodied the present invention to overcome the shortcomings of the state of the art and to obtain these and other purposes and advantages.

### SUMMARY OF THE INVENTION

The present invention is set forth and characterized in the independent claim, while the dependent claims describe other characteristics of the invention or variants to the main inventive idea. Embodiments which do not fall within the scope of the claims do not describe part of the present invention.

In accordance with the above purposes, a modular super-calculation architecture is provided that overcomes the limits of the state of the art and eliminates the defects therein.

According to some forms of embodiment, the modular super-calculation architecture includes a plurality of electronic calculation modules communicating with each other in a network and liquid cooled. In accordance with the present description, each electronic calculation module includes a calculation node, one or more autonomous liquid cooling devices of the calculation mode, an electric power device and a box-like container that encloses and protects inside it at least the calculation node, the electric power device, and the one or more liquid cooling devices. In accordance with the present description each electronic calculation module is independent hydraulically, electrically, in terms of network communication and mechanically at least from the other electronic calculation modules, and can be inserted and/or removed or substituted hot from said architecture.

In this way, each electronic calculation module can operate normally when its external interfaces, for electric power and hydraulic connection, are suitably connected to respective compatible sources of electric energy and cooling liquid.

According to some forms of embodiment, each electronic calculation module includes:
- a calculation node provided with a base plate and a plurality of electronic cards disposed packed side by side on said base plate;
- one or more autonomous liquid cooling devices disposed intermediate between said electronic cards of the calculation node to define one or more cooled groups of cards in a sandwich;
- an electric power device;
- a box-like container that encloses and protects inside it at least the calculation node, and the one or more liquid cooling devices defining said one or more cooled groups of cards in a sandwich, and the electric power device;
so that each electronic calculation module is independent hydraulically, electrically, in terms of network communication and mechanically at least from the other electronic calculation modules, and can be inserted and/or removed or substituted hot from said architecture.

These and other aspects, characteristics and advantages of the present disclosure will be better understood with reference to the following description, drawings and attached claims. The drawings, which are integrated and form part of the present description, show some forms of embodiment of the present invention, and together with the description, are intended to describe the principles of the disclosure.

The various aspects and characteristics described in the present description can be applied individually where possible. These individual aspects, for example aspects and characteristics described in the attached dependent claims, can be the object of divisional applications.

### BRIEF DESCRIPTION OF THE DRAWINGS

These and other characteristics of the present invention will become apparent from the following description of some forms of embodiment, given as a non-restrictive example with reference to the attached drawings wherein:
- fig. 1 is a front view of a modular super-calculation architecture according to forms of embodiment described here;
- fig. 2 is a plan view from above of part of a modular super-calculation architecture according to forms of embodiment described here;
- fig. 3 is a front view of fig. 2;
- fig. 4 is a lateral view of fig. 2;
- fig. 5 is a perspective view of an electronic calculation module of a modular super-calculation architecture according to forms of embodiment described here;
- fig. 6 is a front view in separate parts of an electronic calculation module of a modular super-calculation architecture according to forms of embodiment described here;
- fig. 7 is a rear view in separate parts of an electronic calculation module of a modular super-calculation architecture according to forms of embodiment described here;
- fig. 8 is a schematic representation of the interconnection of the components of an electronic calculation module in accordance with the present description;
- figs. 8B and 8C are perspective views of parts of an electronic calculation module of a modular super-calculation architecture according to forms of embodiment described here;
- fig. 9 is a schematic front view of an electronic calculation module of a modular super-calculation architecture according to forms of embodiment described here;
- fig. 10 is a schematic plan view from above of a calculation node of an electronic calculation module of a modular super-calculation architecture according to forms of embodiment described here;
- fig. 11 is a schematic front view of a calculation node of an electronic calculation module of a modular super-calculation architecture according to forms of embodiment described here;
- fig. 12 is a schematic front view of forms of embodiment of a calculation node of an electronic calculation module of a modular super-calculation architecture according to forms of embodiment described here;
- fig. 13 is a schematic front view of a part of a calculation node of an electronic calculation module of a modular super-calculation architecture according to forms of embodiment described here;
- fig. 14 is a schematic front view of forms of embodiment of a calculation node of an electronic calculation module of a modular super-calculation architecture according to forms of embodiment described here;
- fig. 15 is a schematic front view of forms of embodiment of another part of a calculation node of an electronic calculation module of a modular super-calculation architecture according to forms of embodiment described here;
- fig. 16 is a schematic perspective view of forms of embodiment of a cooling circuit connected to cooling devices of a calculation node of an electronic calculation module of a modular super-calculation architecture according to forms of embodiment described here.

To facilitate comprehension, the same reference numbers have been used, where possible, to identify identical common elements in the drawings. It is understood that elements and characteristics of one form of embodiment can conveniently be incorporated into other forms of embodiment without further clarifications.

### DETAILED DESCRIPTION OF SOME FORMS OF EMBODIMENT

We shall now refer in detail to the various forms of embodiment of the present invention, of which one or more examples are shown in the attached drawing. Each example is supplied by way of illustration of the invention and shall not be understood as a limitation thereof. For example, the characteristics shown or described insomuch as they are part of one form of embodiment can be adopted on, or in association with, other forms of embodiment to produce another form of embodiment. It is understood that the present invention shall include all such modifications and variants.

Forms of embodiment described here refer to a modular super-calculation architecture 10 that includes a plurality of electronic calculation modules 12 communicating with each other in a network and liquid cooled. According to some forms of embodiment, each electronic calculation module 12 includes:
- a calculation node 40 provided with a base plate 42 and a plurality of electronic cards 44, 46, 48 disposed packed side by side on said base plate 42;
- one or more autonomous liquid cooling devices 60 disposed intermediate between said electronic cards 44, 46, 48 of the calculation node 40 to define one or more cooled groups of cards in a sandwich 64, 65;
- an electric power device 74;
- a box-like container 32 that encloses and protects inside it at least the calculation node 40, and the one or more liquid cooling devices 60 defining said one or more cooled groups of cooling cards in a sandwich 64, 65, and the electric power device 74.

According to the present description, each electronic calculation module 12 is independent hydraulically, electrically, in terms of network communication and mechanically at least from the other electronic calculation modules 12, and can be inserted and/or removed or substituted hot from said architecture.

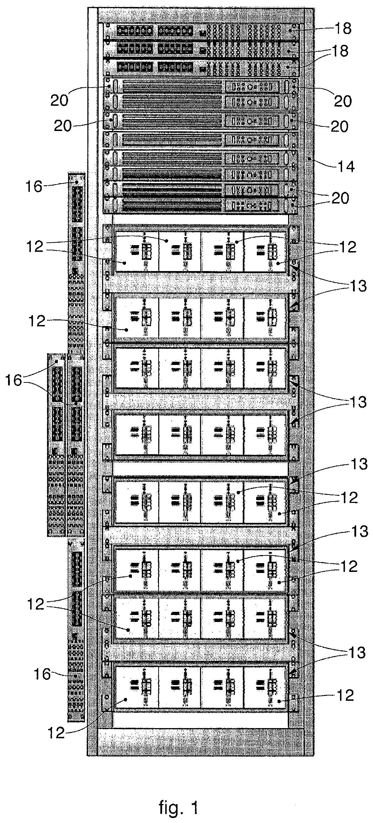

Fig. 1 is used to describe forms of embodiment, which can be combined with all the forms of embodiment described here, of a modular super-calculation architecture 10 according to the present description. In particular, forms of embodiment described here concern a scalable modular super-calculation architecture 10 with levels of computation capacity higher than 1 PetaFlops, or a high capacity processing system or super-calculator (hereafter HPC - High Performance Computer), usable in various fields of application of intensive calculation, such as for example in the field of quantum chromodynamic physics, in fluidothermodynamic simulations or in other calculation scenarios where high processing capacities are required.

The modular super-calculation architecture 10 includes a plurality of said electronic calculation modes 12, or electronic processing modules.

The overall processing required by the applications that are executed on the modular super-calculation architecture 10 can be distributed in a coordinated manner to the individual electronic calculation modules 12 which, therefore, execute a sub-group of operations required by the application.

Each of the electronic calculation modules 12 is provided to perform a predefined group of calculation and processing operations. The electronic calculation modules 12 can be connected to each other by means of a communicating apparatus or network architecture, so as to be able to receive data at input to be processed and to transmit at output to one or more processing units the output data relating to the results of the processing, as well as information on the management and coordination of the system.

The network connection allows to distribute the processing among several electronic calculation modules 12, flexibly and suitable for the specific applications performed, optimizing the use of the processing capacity of the modular super-calculation architecture 10.

Considering that modern systems of parallel calculation are evolving in overall calculation power in the order of Petaflops (1 Petaflop = 10¹⁵ operations per second), the modular super-calculation architecture 10 can provide to use a high number of calculation modules 12 per installation, for example 256 electronic calculation modules installed in 4 cabinets for an overall calculation power of about 1 PetaFlops.

As described above, in possible implementations a network architecture can be provided usable for communicating between the different electronic calculation modules 12 that form the modular super-calculation architecture 10, which can be the known type, high speed and low power, for example Infiniband standard. One example of possible network architecture is described in WO-A-2012/066414.

In possible implementations, the electronic calculation modules 12 can be disposed and grouped spatially according to a configuration in lines and columns. For example each line of electronic calculation modules 12 can include two, three, four, five or even more than five electronic calculation modules 12. Furthermore, for example, a single line of electronic calculation modules 12 can be provided, or a plurality of lines of electronic calculation modules 12 can be provided, stacked one on top of the other, to define for example different vertical levels of lines of electronic calculation modules 12. In possible example embodiments, two, three, four, five, six, seven, eight or even more than eight lines of electronic calculation modules 12 can be provided, thus defining respective vertical levels 13 of electronic calculation modules 12. This disposition can be repeated in space, for example two columns of electronic calculation modules 12 can be provided, in a front-back disposition, but also three, four, five, six or more than six columns, front-back and adjacent.

In possible implementations, described with reference for example to fig. 1, the modular super-calculation architecture 10 can include a containing cabinet or rack 14, to contain, grouped together for example as described above, the electronic calculation modules 12. Several containing cabinets 14 can also be provided, each containing their own electronic calculation modules 12, according to a modular development of the modular super-calculation architecture 10 in question. For example, each electronic calculation module 12 can be inserted, in a selectively removable manner, into the containing cabinet 14. To this purpose, it is possible to provide that each electronic calculation module 12 is provided, for example externally along the sides, with sliding guides configured to cooperate with counter-guides, for example such as rails, of the containing cabinet 14 for positioning and inserting/removing the electronic calculation module 12 into/from the containing cabinet 14. Furthermore, as explained in more detail hereafter, each electronic calculation module 12 can be inserted into the containing cabinet 14 and autonomously connected both electrically and hydraulically with respective electric power supplies and cooling liquid supplies, and also with a data communication network with the outside. In practice this obtains the modular nature of the modular super-calculation architecture 10 according to the present description, since each electronic calculation module 12, which can also be considered metaphorically as a brick to obtain the architecture, can be coupled with "n" other electronic calculation modules 12 in a scalable manner, advantageously without an upper limit, satisfying for each electronic calculation module 12 at least the needs of electric connection and cooling, and also of data communication with the outside.

Furthermore, given its modular nature, each electronic calculation module 12 can easily be removed for repairs, maintenance or control, and also replaced, definitively or temporarily. In substance, each electronic calculation module 12 can be independent, as described above, with respect to the other modules and can be connected and disconnected quickly hot ("hotswap"), that is, without switching off or de-activating the system.

To this purpose, in possible forms of embodiment, each electronic calculation module 12 can provide a feed interface electric circuit of the hot swap type, rapid disconnection hydraulic circuits, internal interconnections optimized to reduce the interface connections with the outside to a reduced number of elements, for example four elements, including electric power connection, data network connection, input and output of the cooling circuit. Furthermore, again with the purpose of obtaining an electronic calculation module 12 that can be connected and disconnected quickly, a mechanical spatial organization of the interface connections is provided that maximizes the safety of the operations to connect/ disconnect the electronic calculation module 12 in the architecture 10.

In possible implementations, described with reference to fig. 1, the modular super-calculation architecture 10 can include a plurality of network communication switches 16 for communicating between the various electronic calculation modules 12. For example, some network communication switches 16 can be provided for front-back communication between the electronic calculation modules 12 while others can be provided for back-front communication between the electronic calculation modules 12. The network communication switches 16 can for example implement a network communication according to FDR Infiniband standard, hereafter IB, wide band (56 Gbps per node) and low latency, less than about 1 microsecond. For example, the network communication switches 16 can include FDR IB switches, for example one, two, three, four or even more than four, each switch with a plurality of gates, for example 36 gates. For example each FDR IB switch can include a plurality of internal IB gates, connected to an equal number of IB gates of the electronic calculation modules 12, and a plurality of external IB gates, offered on external connectors for external interconnections. With reference to fig. 1 for example, the network communication switches 16 for communicating between the various electronic calculation modules 12 can be mounted on one of the external walls of the containing cabinet 14.

In possible implementations, described with reference to fig. 1, the modular super-calculation architecture 10 can include a plurality of Ethernet switches 18, for network communication with the outside. For example, one, two, three, four or even more than four Ethernet switches 18 can be provided. With reference to fig. 1 for example, the Ethernet switches 18 can be disposed in the upper part, for example inside the containing cabinet 14, in this case above a respective column of electronic calculation modules 12.

In possible implementations, described with reference to fig. 1, the modular super-calculation architecture 10 can include a plurality of power supply units (PSU) 20. The power supply units 20 can be configured for connection and electric power to the electronic calculation modules 12, and also to the possible network communication switches 16 and Ethernet switches 18. For example, with reference to fig. 1, the power supply units 20 can be disposed inside the containing cabinet 14, between the top of a respective column of electronic calculation modules 12 and said Ethernet switches 18. In particular, each electronic calculation module 12 is provided with its own electric power system, as described hereafter.

With reference to forms of embodiment described using fig. 1, which can be combined with all the forms of embodiment described here, the modular super-calculation architecture 10 can provide a liquid cooling system, to dissipate the heat produced by the electronic calculation modules 12. In particular, each electronic calculation module 12 is provided with its own liquid cooling system as described hereafter. According to forms of embodiment described here, each electronic calculation module 12 can therefore be autonomous at least in terms of electric power and liquid cooling with respect to the other electronic calculation modules 12.

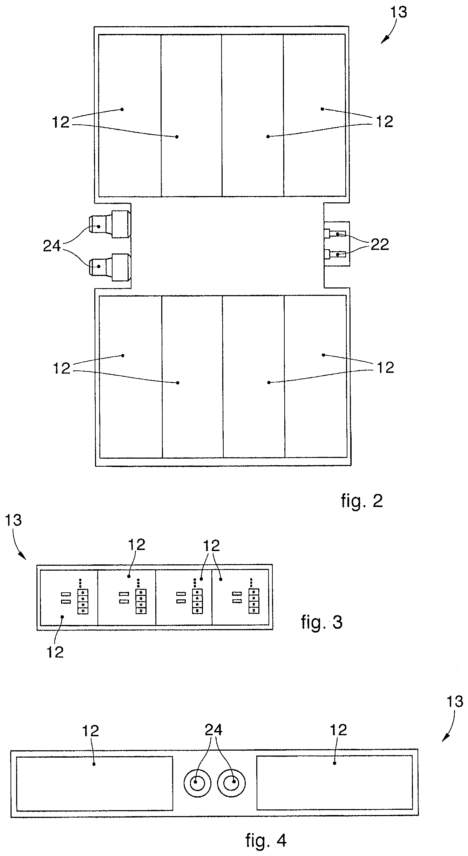

Figs. 2, 3 and 4 are used to describe forms of embodiment of groups, for example two groups, one at the front and one at the rear, of electronic calculation modules 12 of a determinate vertical level 13 of the modular super-calculation architecture 10 described here. With reference to fig. 2, four front electronic calculation modules 12 can be provided for example in a line, and four rear electronic calculation modules 12 in a line.

With reference to forms of embodiment described using fig. 2, and which can be combined with all the forms of embodiment described here, the modular super-calculation architecture 10 can provide for example for each vertical level 13 of electronic calculation modules 12, one, two or more main electric connectors 22, to which the electric connections of the electronic calculation modules 12 of the respective level refer, when inserted in the cabinet 14. A front main electric connector 22 can be provided for the front electronic calculation modules 12, and a back main electric connector 22 for the back electronic calculation modules 12. For example, the main electric connectors 22 can be provided for example for a 12 Vdc 1000 A feed, in the case shown by way of example for connecting four electronic calculation modules 12.

With reference to forms of embodiment described using fig. 2, and which can be combined with all the forms of embodiment described here, the modular super-calculation architecture 10 can provide for example for each vertical level of electronic calculation modules 12, at least two or more main hydraulic connectors 24, at least one for delivery and one for return, to which the hydraulic connections of the liquid cooling devices 60 of each of the electronic calculation modules 12 of the respective level refer, such as for example hydraulic connectors 56, described in more detail hereafter. A front pair of main hydraulic connectors 24 can be provided for the front electronic calculation modules 12 and a back pair of main hydraulic connectors 24 for the back electronic calculation modules 12. For example, the main hydraulic connectors 24 can have rapid disconnection and be drip-free. For example, the main hydraulic connectors 24 can be the quick disconnect zero spillage type, which are provided for example with a double closing valve, which at the moment of mechanical disconnection interrupts the respective hydraulic circuits, preventing the spillage of heat-carrying liquid.

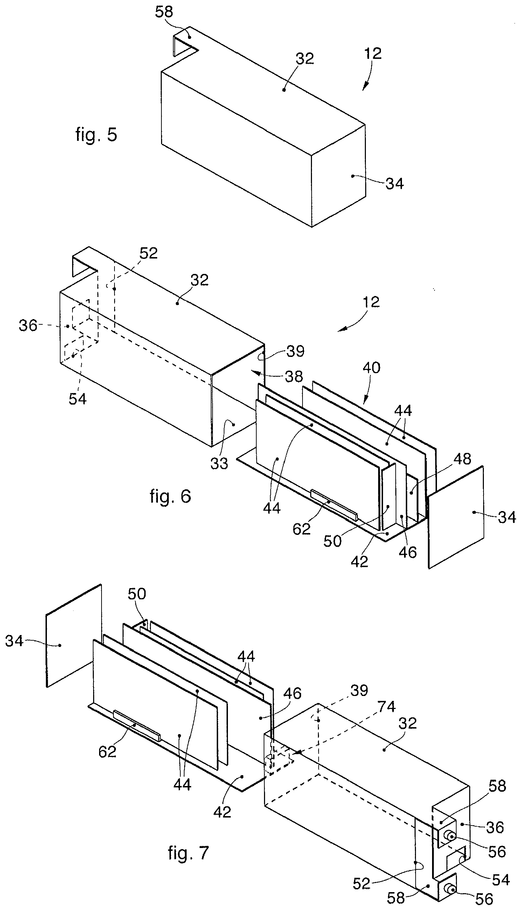

Furthermore, in forms of embodiment according to the present description, which can be combined with all the forms of embodiment described here, each electronic calculation module 12 includes its own electric power device 74 (see fig. 7), which for example can be provided with a main power connector 76, for which hereafter some possible forms of embodiment will be described by way of example.

Figs. 5, 6 and 7 are used to describe forms of embodiment, which can be combined with all the forms of embodiment described here, of an electronic calculation module 12 usable in the modular super-calculation architecture 10 described here. The electronic calculation module 12 can include the box-like container 32, containing a respective calculation node 40, which essentially obtains the computation unit of the electronic calculation module 12.

According to the present description, the electronic calculation module 12, and in particular the calculation node 40, can include a plurality of electronic cards and/or other electronic components suitable for its functioning, which will be described in more detail hereafter.

In possible forms of embodiment, the electronic cards or components can be made specifically to serve the purpose required, and hence in an optimal manner to maximize the integration of the calculation node 40 and hence the overall bulk and maximize the overall performance thereof.

In other advantageous forms of embodiment, the electronic calculation module 12 according to the present description can be made using electronic cards and electronic components meeting predefined commercial standards that determine their main characteristics, such as standard form factors and electric and mechanical interface, allowing a simpler embodiment of the electronic module. In this way it is possible for example not only to contain costs but also to satisfy the ever-growing need to simplify and facilitate the modular nature of current super-calculation systems, for this purpose using electronic cards and components that are available on the market, satisfying recognized international standards suitable for the purpose such as, to quote only a few, by way of non-restrictive example, PCI express (PCIe), COM express (COMe), Versa Module Eurocard (VME) and others.

In these cases, when pre-determined standards are adhered to, the bulk, standard form factors and interface of the individual electronic cards and components of the calculation node 40 can be characteristics that are obligatorily fixed and can constrain the solutions to be adopted in order to maximize integration and performance of the electronic calculation module 12.

In possible forms of embodiment, the calculation node 40 can be inserted for example into a respective internal containing chamber 38 delimited by the box-like container 32, which can be accessed through a front insertion aperture 39. The box-like container 32 is configured to enclose and protect the calculation node 40 from the external environment. For example, a front closing panel 34 can be provided, positionable to close the entrance aperture 39, or a rear closing wall or panel 36. The front panel 34 can be removable for example, to allow to insert/remove the calculation node 40, and also for example maintenance, control and repairs on the calculation node 40 housed in the internal containing chamber 38.

Alternatively, the box-like container 32 can be removed by extracting it from the electronics contained in the electronic calculation module 12, essentially represented by the calculation node 40, so as to access completely all the internal elements, electronic cards or similar electronic components of the electronic calculation module 12.

According to some forms of embodiment, the electronic cards 44, 46, 48 of each calculation node 40 are at least a central processing card 46, at least a network card 48, one or more computational accelerating cards 44 and a possible I/O card 50.

In particular, according to possible implementations, each calculation node 40 can include at least one central processing card or CPC 46.

Furthermore, each calculation node 40 can include at least one network card or controller 48, such as for example an Infiniband (IB) controller, which can have for example an overall maximum band of about 56 Gbps.

Furthermore, each calculation node 40 can include one or more computational accelerating cards or CAC 44, which advantageously provide to accelerate parallel computations. For example, two, three four or even more than four computational accelerating cards 44 can be provided.

In some forms of embodiment, the central processing card CPC 46, network card 48 and computational accelerating cards CAC 44 can be the customized type, that is, made specifically to perform the function relating to a specific use of the electronic calculation module 12 for the modular super-calculation architecture 10.

In advantageous forms of embodiment, the central processing card CPC 46, network card 48 and computational accelerating cards CAC 44 can be made according to recognized international standards and hence purchasable as components available on the market.

In particular, the central processing card CPC 46, network card 48 and computational accelerating cards CAC 44 can be advantageously chosen belonging to the same standard, for example using exclusively cards of the PCI express type. Alternatively, for questions of suitability, availability on the market or technical solution adopted, some electronic cards, for example the central processing card CPC 46 and the network card 48 can be the standard PCIe type, while the one or more computational accelerating cards CAC 44 can belong to the COMe standard.

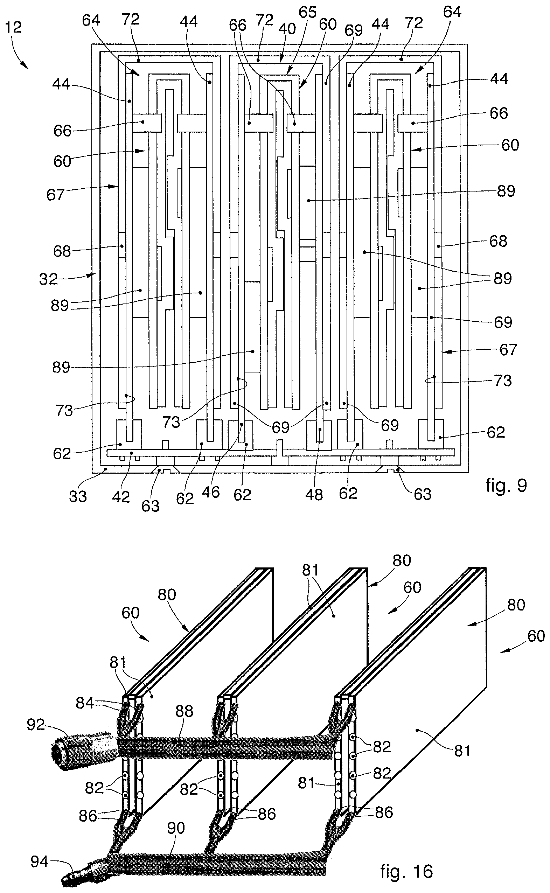

For example, the CPC 46 and the one or more computational accelerating cards CAC 44, like for example the network card 48 or other possible cards present, can have electronic components 89 that represent hot spots to be cooled (see for example figs. 9, 10 and 11).

In possible implementations, each calculation node 40 can include at least an I/O card 50, for example configured to supply additional network connections, video ports and other possible interfaces for monitoring and/or maintaining the calculation node 40.

Advantageous forms of embodiment of the present invention can be provided to satisfy the need to "mask" the possible complexity or in any case plurality of electronic cards inside the electronic calculation module 12 with respect to the outside, for example, in terms of network communication, management of the input and output signals and electric power.

In particular, it is possible to obtain that the electronic calculation module 12 is seen externally not as a group of different electronic cards and components of variable complexity and output, but as a single entity that supplies uniform outputs that can be managed efficiently as such in terms of modularity.

In particular, the present invention can allow to make equivalent, with regard to the outside, a plurality of components and electronic cards, organized in groups and associated to the electronic calculation module itself, to a single calculation module with a greater or lesser complexity. This is in particular to satisfy the requirements of real modularity of the modular super-calculation architecture 10 in question.

To this purpose, forms of embodiment of the present invention can provide the choice of a suitable communication network 95 inside the electronic calculation module 12 and particular inside the calculation node 40, which renders efficient the communication between the various components and electronic cards and makes available, toward the outside, a signal output comparable with or similar to the output that an individual, non-complex calculation module would have.

According to possible forms of embodiment, each calculation node 40 can include the base plate or midplane 42, configured to allow at least connection for electric power, internal communication between the cards and components of the calculation node 40 and network communication of the calculation node 40 toward the outside. For example, the base plate 42 can be disposed and possibly attached to a bottom 33 of the box-like container 32 (see for example figs. 6 and 9).

The base plate 42 is therefore configured to supply basic functions to the cards that constitute the calculation node 40; in particular it can receive primary electric power and network connection, and can condition them and distribute them to the individual cards of the calculation node 40. In particular, the base plate 42 can include the electric power device 74. For example, the base plate 42 can provide the active electronic circuitry needed to supply electric power from outside to the cards or components of the electronic calculation module 12, such as for example the main power connector 76 of the electric power device 74, advantageously disposed at the rear (see for example fig. 7).

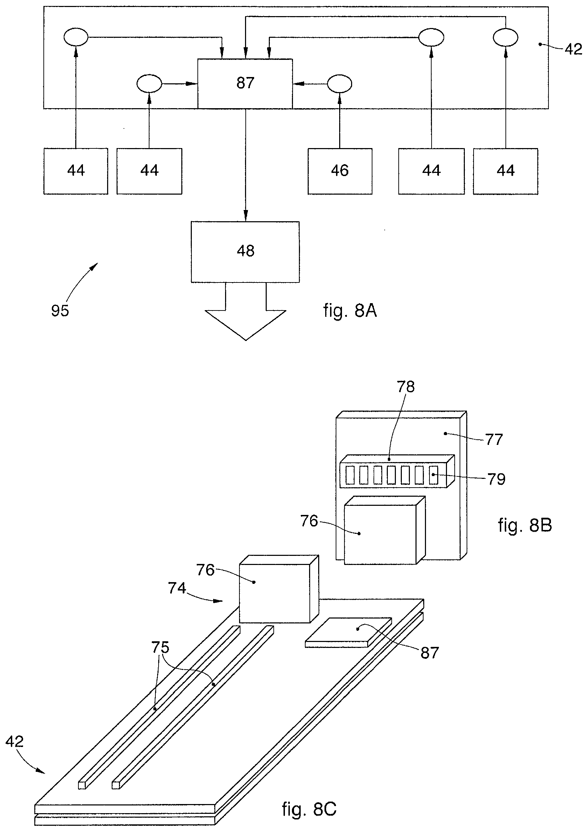

According to possible forms of embodiment, described for example with reference to figs. 8B and 8C, the main power connector 76 can be disposed on a rear mini card 77 provided on the rear side of the base plate 42 which can also possibly include for example an address selector 78 to set the hardware address corresponding to the electronic calculation module 12 installed. In particular, the address selector 78 can include a plurality of dip switches 79 that can be suitably set to encode the desired hardware address information. This information can be supplied to the electronic calculation module 12 for example with the main power connector 76, by means of other dedicated pins. The electronic circuitry of the base plate 42 can also possibly include logic management components of the electric connection which is distributed to the cards, and components for monitoring the power absorbed and hot plug components.

Advantageously, the base plate 42 can implement the cited internal communication network 95 among the components and electronic cards of the calculation node 40. For example components can be provided to manage a communication bus between the various cards that constitute the calculation node 40, support and electric connection connectors 62 for the cards and the necessary management, control and supervision logic of the internal communication network 95.

In the example case of using only electronic cards making up the calculation node 40, for example the PCIe type, an efficient architecture of the internal communication network 95 can be the one shown in fig. 8A, and can require for example at least one controller and PCIe switch 87 and connectors 62, for example standard PCIe connectors 75.

The connectors 62 can be installed on the base plate 42, and this in turn can be associated with the bottom 33 of the box-like container 32, by means of attachment screws 63 (see for example fig. 9). For example, the CPC 46, like the possible network card or controller 48 and one or more computational accelerating cards 44, can be connected to the base plate 42 by means of the card connectors 62.

In possible implementations, two pairs of computational accelerating cards 44 can be provided, adjacent to each other and disposed at the sides of the calculation node 40, and a pair of cards formed by CPC 46 and network card 48, with possible IO card 50, in an intermediate position, to define the packed, side to side conformation.

The calculation node 40 can be connected by means of suitable electric connection connectors and cables to an external electric energy supply, for example referring to said main electric connectors 22. To physically connect the calculation node 40 to the electric power via cable, an electric connection window 54 can be provided in the box-like container 32, for example made in the rear wall 36, which can be configured to expose the main power connector 76 of the base plate 42 to the outside, which typically can be flush with the electric connection window 54, or slightly protruding.

In possible implementations, a hydraulic connection window 52 can be made in the box-like container 32, for example made in the rear wall 36, for the liquid cooling system of the electronic calculation module 12. For example, supports 58 can be provided on the hydraulic connection window 52, such as for example brackets or suchlike, for the hydraulic connectors 56. The hydraulic connectors 56 can be provided for connection on one side to pipes from the cooling system of the calculation node 40, and on the other side to pipes or connectors that are then connected for example to the main hydraulic connectors 24 as above. The hydraulic connectors 56 can also be the rapid connection type and dripless as described above.

Advantageously the hydraulic connectors 56 can be provided in a more protruding position from the body of the box-like container 22, with respect to the electric power device 74, like the main power connector 76 of the base plate 42, which instead is more retracted and for example can be exposed at the electric connection window 54. The desired protrusion or advanced position of the hydraulic connectors 56 can be obtained for example by providing that the supports 58 are of adequate length, extending beyond the rear wall 36.

This technical solution can be very advantageous because, by virtue of their more protruding geometric position, with the insertion of the electronic calculation module 12 in the cabinet 14, first the hydraulic connectors 56 are connected to the source of cooling liquid and only later, once the hydraulic connection has been established, sealed and secure, is the electric power connected to the main power connector 76, which is in a more retracted position, so that the safety of the system is maximized. This also applies if the electronic calculation module 12 is extracted and disconnected, because firstly, with a movement opposite the insertion movement, the electric power is disconnected and only after that is the hydraulic circuit disconnected. Consequently, a univocal spatial conformation can be defined, for example on the right the protruding part for connection to the cooling circuit and on the left the retracted part for electric connection, which not only supplies the guarantee of safety as above, but can also allows to identify a correct and univocal insertion position for the electronic calculation module 12.

Forms of embodiment in which the box-like container 32 is open, providing for example the hydraulic connection window 52, and the electric connection window 54, can be advantageous in terms of economic cost, suitable for solutions in installation sites that are not critical or aggressive.

On the contrary, forms of embodiment in which the box-like container 32 is completely closed, that is, without the hydraulic connection window 52 and the electric connection window 54, can be provided for example in uncontrolled, critical or aggressive installation sites, where a high level of protection of the cards and other components in the electronic calculation module 12 must be guaranteed.

Figs. 9, 10 and 11 are used to describe forms of embodiment, which can be combined with all the other forms of embodiment described here, of a possible liquid cooling system provided in an electronic calculation module 12 according to the present description. In particular, the cooling system can include one or more of said liquid cooling devices 60 for the electronic calculation module 12, each of which can be dedicated for example to a respective component of the calculation node 40. In particular, the liquid cooling devices 60 can be interposed between the electronic cards 44, 46, 48 and for example a cooling liquid device 60 can be provided disposed adjacent to the CPC 46; in the same way, liquid cooling devices 60 can be provided disposed adjacent to the computational accelerating cards 44, and also possibly at the network card 48. For example, a liquid cooling device 60 can be provided between two computational accelerating cards 44, and a liquid cooling device 60 between the CPC 46 and the network card 48.

In possible implementations therefore, the cooled groups of cards in a sandwich 64, 65 can include cooled groups of computational accelerating cards in a sandwich 64 and/or cooled groups of central processing/ network cards in a sandwich 65 respectively including one or more liquid cooling devices 60, coupled, that is, adjacent or packed side by side, with respective one or more computational accelerating cards 44 and/or central processing card 46 and network card 48 disposed on the base plate 42 of the calculation node 40, in particular disposed in this case all on the same side, transversely, more particularly perpendicularly, to a lying plane defined by the base plate 42.

For example, it may be provided to make a cooled group of cards with a layered or sandwich structure 64, 65 for each liquid cooling device 60 and the respective computational accelerating cards 44 or the CPC 46 and network card 48. For example, a cooled group of computational accelerating cards in a sandwich 64 can be provided, which includes two facing computational accelerating cards 44 and between them a liquid cooling device 60. The cooled group of computational accelerating cards in a sandwich 64 can be duplicated on the two sides of the calculation node 40. In the same way, a cooled group of central processing/network cards, or CPC/network cards in a sandwich 65, can be provided, which includes the CPC 46 and the network card 48 facing each other, and in the middle of them a liquid cooling device 60. This cooled group of CPC/network cards in a sandwich 65 can for example be intermediate in the calculation node 40, between two cooled groups of computational accelerating cards in a sandwich 64.

In some forms of embodiment, each cooled group of cards in a sandwich 64, 65 can be associated with plate-type heat dispersion devices 67 cooperating with the respective liquid cooling devices 60 and said central processing card 46, network card 48 and one or more computational accelerating cards 44. With reference to forms of embodiment described here, it may be provided that each plate-type heat dispersion device 67 is configured to at least partly disperse, distribute and remove the heat generated by electronic components 89, that is, hot spots, on the side of the cards not in contact with the liquid cooling device 60 and hence not dissipated by liquid.

In possible implementations, the plate-type heat dispersion devices 67 can include, for each card to be cooled, a single dissipation plate coupled laterally in contact with a corresponding card, such as the CPU 46 and I/O card 50, or the computational accelerating cards 44, respectively in the cooled group of CPC/network cards in a sandwich 65 or cooled group of computational accelerating cards in a sandwich 64.

In forms of embodiment described using fig. 9, the plate-type heat dispersion device 67 can be for example formed by a plate bent back on itself to define two opposite lateral support walls 69, possibly connected by a connection segment 72 to define a housing 73 in which to insert the respective liquid cooling device 60 and the possible computational accelerating cards 44 or CPC 46 and network card 48 (see for example fig. 9). The connection segment 72, and the housing 73 thus defined, can have sizes such as to keep the card to be cooled in contact with the plate-type heat dispersion device 67 when in use.

For example, the bent plate that can achieve the plate-type heat dispersion device 67 can be essentially shaped like an upside down U, and in possible implementations obtained for example by bending a single plate or sheet, for example made of aluminum or similar heat conductive metal or alloys suitable for the purpose.

In particular, the liquid cooling device 60 can be inserted inside the plate-type heat dispersion device 67, as we said for example, in the housing 73, for example in the center, with respect to the internal faces of the plate-type heat dispersion device 67.

For example the connection segment 72 of the plate-type heat dispersion device 67 can close at the upper part the zone where the liquid cooling device 60 is inserted, while the support walls 69 delimit it laterally.

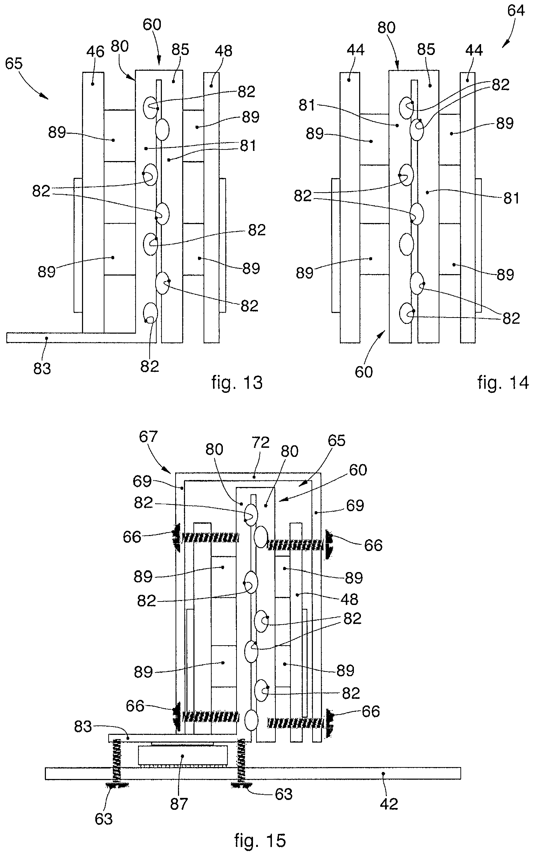

Attachment members 66 can be provided, for example screws, to constrain the liquid cooling device 60 for example to the CPC 46, and/or the network card 48, or to the computational accelerating cards 44, and to the plate-type heat dispersion device 67, in particular to the support walls 69 (see fig. 15 also).

The CPC 46 and the network card 48, or the computational accelerating cards 44, can be disposed inside the plate-type heat dispersion device 67, in particular laterally on the internal faces of the plate-type heat dispersion device 67, in contact with them. In this case too, attachment members 68 can be provided to constrain the CPC 46 and network card 48, or the computational accelerating cards 44, in contact with the plate-type heat dispersion device 67.

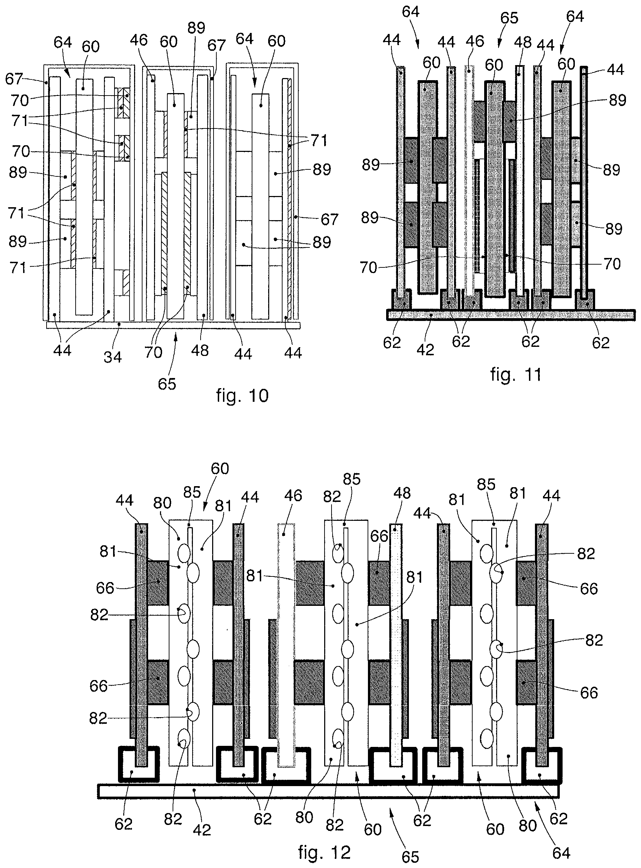

In possible forms described using figs. 10 and 11, which can be combined with all the forms of embodiment described here, between the liquid cooling device 60 and the CPC 46 and network card 48 one or more protruding dissipation and heat exchange blocks 70 can be provided, also called "Local Thermal Links", for example typically disposed in contact on one side with a respective CPC 46 and on the other side with one face of the liquid cooling device 60, to compensate for the differences in height between the various components. The protruding dissipation and heat exchange blocks 70 can also be disposed for example between the plate-type heat dispersion device 67 and computational accelerating card 44 (see for example fig. 10).

According to some forms of embodiment, which can be combined with all the forms of embodiment described here, the protruding dissipation and heat exchange blocks 70 can be disposed in a coordinated manner with the position of the components, or hot points, to be cooled, computational accelerating cards 44, CPC 46 and/or network card 48, and have shape and sizes mating with those of the electronic components from which heat is extracted during functioning.

In some forms of embodiment, one or more layers of thermal interface material 71, also called TIM, can be provided, for example of a known type. The one or more layers of thermal interface material 71 can be interposed for example between one cooling device 60 and a corresponding electronic component 89 to be cooled, for example of the computational accelerating cards 44 or CPC 46 and/or network card 48, so as to increase the efficiency of the heat transfer through heat conduction of the liquid cooling device 60, and/or associated or also adjacent to one or more of the protruding dissipation and heat exchange blocks 70, for example between a computational accelerating card 44 and a corresponding protruding dissipation and heat exchange block 70.

The layers of thermal interface material 71 and/or protruding dissipation and heat exchange blocks 70 can have a transverse thickness such as to contact during use, either directly or indirectly, an associated component or hot point.

According to the present description and with reference for example to forms of embodiment described using fig. 9, which can be combined with all the forms of embodiment described here, it is clear that each calculation node 40 is completely enclosed and protected by the box-like container 32 of the electronic calculation module 12. In this way, if any intervention for repairs, maintenance, replacement or control on the calculation node 40 or its components were to be necessary, it is possible to replace the corresponding electronic calculation module 12 with a new one and/or replacement without switching off or de-activating the system and safely, by completely extracting the box-like container 32 from the place where it is installed and transporting it, closed and protected, to a suitable place, which can advantageously be different, with more favorable and safer operating conditions than the place where it is installed, where the necessary operation of repairs, maintenance, replacement or control can be carried out. Consequently, it is possible to maximize the system uptime, without interrupting service. Furthermore, even if the electronic calculation module 12 and the modular super-calculation architecture 10 are installed in extreme or hostile environments for example in terms of pollution, dust, working temperature, cleaning or suchlike, there is no risk of damaging the content of the electronic calculation module 12 during extraction, transport and opening thereof in order to carry out the above operations.

Furthermore, with reference to forms of embodiment described using figs. 9, 10 and 11, which can be combined with all the forms of embodiment described here, it may be provided that each liquid cooling device 60 is always alternated with a "hot" component, such as computational accelerating cards 44, CPC 46, network card 48, with respect to another liquid cooling device 60 of the calculation node 40, avoiding liquid cooling devices 60 that are directly adjacent or alongside each other. In this way, the configuration of the calculation node 40 is more flexible, positioning the various electronic cards, for example computational accelerating cards 44, CPC 46, network card 48, I/O card 50 nearer, without interference between two facing liquid cooling circuits. Furthermore, in this way it is possible to simplify the production of the liquid cooling device 60, that is, to make only one type for any card to be cooled and to direct it always in the same way with respect to the electronic calculation module 12, so as to dispose the delivery and outlet of the cooling liquid all on the same side of the electronic calculation module 12, for example toward the rear side, as in this way they are easier to manage and to connect.

Figs. 12, 13 and 14 are used to describe forms of embodiment, which can be combined with all the forms of embodiment described here, of a liquid cooling device 60 usable according to the present description and which includes a cooling plate device 80. For example the cooling plate device 80 can be formed by two adjacent cooling walls 81. For example the cooling plate device 80 can be made as a plate bent back over itself which defines the cooling walls 81, which are facing and opposite each other.

In other forms of embodiment, described for example using figs. 12, 13 and 14, the cooling plate device 80 can be formed by two distinct walls or plates, adjacent to each other, at the sides of the card or component to be cooled.

Possible forms of embodiment in which the cooling plate device 80 and the plate-type heat dispersion device 67 are formed by respective and distinct adjacent walls or plates at the sides of the card to be cooled, to define a simple sandwich structure, are described for example in the application for a patent of industrial invention filed in Italy under VI2013A000273 in the name of the present Applicant.

In some forms of embodiment, described for example using figs. 12, 13, and 14 and which can be combined with all the forms of embodiment described here, the liquid cooling device 60 can also include a plurality of cooling pipes 82, incorporated, integrated, drowned or in any case internal and contained in the cooling plate device 80 and organized in a cooling circuit that develops between one or two entrances and one or more outlets. For example, each of the cooling walls 81 of the cooling plate device 80 can have its own hydraulic cooling circuit formed by its own cooling pipes 82, with its own entrance and its own outlet for the cooling liquid. The cooling pipes 82 are configured to receive a cooling liquid which can thus flow through the cooling pipes 82 and obtain the desired cooling.

In possible implementations according to the present description, the cooling plate device 80 can be made, for example, as we said, by a bent plate that can be essentially shaped like an upside down U, and for example with the two cooling walls 81 facing each other and an upper connection segment 85 (see fig. 12 for example). In possible implementations, the cooling plate device 80 can be obtained for example by bending a single plate or sheet, for example made of aluminum or similar heat conductive metal or alloys suitable for use, in particular with heat exchange properties suitable for the purpose.

Otherwise, as we said, in other possible implementations the cooling plate device 80 can be formed by two distinct walls or plates at the sides of the card to be cooled.

In possible forms of embodiment, which can be combined with all the forms of embodiment described here, the liquid cooling device 60 can be made for example with the roll-bond technology, typically using aluminum panels or equivalent metal material with heat exchange, which are worked and reciprocally coupled making the circuit for the cooling liquid inside. In possible implementations, described for example with reference to the cooled group of CPC/network cards in a sandwich 65, but for example applicable also to the cooled group of computational accelerating cards in a sandwich 64, the cooling plate device 80 can be provided with a bent basic cooling blade 83, at a lower end, which can be made of the same heat conductive material and which can contribute to cooling the base plate 42 by heat conductivity. The bent basic cooling blade 83, which can be in direct or indirect contact with the base plate 42, can also provide a point of attachment, for example by means of screws 63, to the base plate 42 itself (see for example fig. 15).

With reference to forms of embodiment described using fig. 15, for example for the case of CPC 46 and network card 48, and which can be combined with all the forms of embodiment described here, the bent basic cooling blade 83 can be used to dissipate heat generated by an electronic component present on the base plate 42, for example the controller PCIe 87.

Fig. 16 is used to describe forms of embodiment, which can be combined with all the forms of embodiment described here, of the cooling system of an electronic calculation module 12 by means of liquid cooling devices 60 according to the present description and which provides a single delivery collector 88 for the cooling liquid and a single outlet collector 90 of the cooling liquid, to which advantageously each of the liquid cooling devices 60 pertain. In particular, the delivery collector 88 and outlet collector 90 are configured to serve all the liquid cooling devices 60 of the electronic calculation module 12, for example three, which for example typically form two cooled groups of computational accelerating cards in a sandwich 64 at the sides of an intermediate or central cooled group of CPC/network cards in a sandwich 65.

In possible implementations, the delivery collector 88, like the outlet collector 90, can be provided with a respective main delivery connector 92 and a respective main outlet connector 94. In this way, the delivery collector 88 can be connected to a supply of cooling liquid by means of the main delivery connector 92, while the outlet collector 90 can be connected to a discharge of the used cooling liquid by means of the main outlet connector 94, to be returned to low temperature. For example the main delivery connector 92, like the main outlet connector 94, can be connected by means of suitable pipes to the main hydraulic connectors 24 of the modular super-calculation architecture 10 (see for example figs. 2 and 4).

According to some forms of embodiment described here, the main delivery connector 92 and the main outlet connector 94 can be attached on the closing rear wall or panel 36 of the box-like container 32, so as to obtain the hydraulic connectors 56 described above, to define a rigid interface of mechanical attachment and hydraulic connection between the inside of the electronic calculation module 12 and the main hydraulic connectors 24 of the main circuit of the liquid cooling system of the architecture 10.

According to some forms of embodiment described here, which can be combined with all the forms of embodiment described here, both the main delivery connector 92 and the main outlet connector 94 can be the type without dripping, or quick disconnect zero spillage.

In possible implementations, the delivery collector 88 can be provided with delivery pipes 84 to supply the cooling liquid to the respective liquid cooling device 60, in particular one or more delivery pipes 84 for each liquid cooling device 60 to be served. For example, in the case of a liquid cooling device 60 that includes a cooling plate device 80 formed by two cooling walls 81 with respective internal cooling pipes 82, two delivery pipes 84 can be provided, one for each cooling wall 81 of each liquid cooling device 60.

In the same way, in possible implementations, the outlet collector 90 can be provided with outlet pipes 86, to receive and extract the used cooling liquid from the respective liquid cooling device 60, for example one or more outlet pipes 86 for each liquid cooling device 60 to be served. For example, in the case of a liquid cooling device 60 that includes a cooling plate device 80 formed by two cooling walls 81 with respective internal cooling pipes 82, two outlet pipes 84 can be provided, one for each cooling wall 81 of each liquid cooling device 60.

In possible implementations, the delivery pipes 84 and/or the outlet pipes 86 can be made as connector pipes, for example made of copper-aluminum, welded on one side to each cooling plate device 80, for example to the respective cooling walls 81, in correspondence with the respective cooling pipes 82, and on the other side to the respective delivery 88 and outlet 90 collectors.

It is clear that modifications and/or additions of parts may be made to the modular super-calculation architecture 10 as described heretofore, without departing from the field and scope of the present invention.

It is also clear that, although the present invention has been described with reference to some specific examples, a person of skill in the art shall certainly be able to achieve many other equivalent forms of modular super-calculation architecture, having the characteristics as group forth in the claims and hence all coming within the field of protection defined thereby.

Although the above refers to forms of embodiment of the invention, other forms of embodiment can be provided without departing from the main field of protection, which is defined by the following claims.

## Claims

1. Modular super-calculation architecture comprising at least one containing rack (14) in which is inserted, in a selectively removable manner, a plurality of liquid cooled electronic calculation modules (12) communicating with each other in a network, wherein each electronic calculation module (12) comprises:
- a calculation node (40) provided with a base plate (42) and a plurality of electronic cards (44, 46, 48) disposed packed side by side on said base plate (42), said electronic cards (44, 46, 48) comprising at least one central processing card (46), the base plate (42) being provided with card connectors (62) for connecting the electronic cards (44, 46, 48) to the base plate (42);
- one or more liquid cooling devices (60) disposed intermediate between said electronic cards (44, 46, 48) of the calculation node (40) to define one or more cooled groups of cards in a sandwich (64, 65), said one or more liquid cooling devices (60) being autonomous with respect to liquid cooling devices (60) of the other electronic calculation modules (12), said one or more liquid cooling devices (60) each comprising a cooling plate device (80) having its own hydraulic cooling circuit formed by a plurality of cooling pipes (82);
- an electric power device (74);
- a box-like container (32) that encloses and protects inside it at least the calculation node (40) and the one or more liquid cooling devices (60) defining said one or more cooled groups of cards in a sandwich (64, 65), and the electric power device (74), said box-like container (32) delimiting an internal containing chamber (38) that contains the respective calculation node (40);
so that each electronic calculation module (12) is at least hydraulically, electrically in terms of network communication, and mechanically independent from the other electronic calculation modules (12), and can be inserted and/or removed hot or substituted hot into/from said architecture.

2. Architecture as in claim 1, wherein said containing chamber (38) is provided with a front insertion aperture (39), a front closing panel (34), and a rear closing wall (36).

3. Architecture as in claim 1 or 2, wherein said electronic cards (44, 46, 48) comprise at least a central processing card (46), at least a network card (48), one or more computational accelerating cards (44) and a possible I/O card (50).

4. Architecture as in claim 3, wherein each cooled group of cards in a sandwich (64, 65) provides a plurality of liquid cooling devices (60), each disposed respectively at each of said central processing card (46), network card (48), and one or more computational accelerating cards (44).

5. Architecture as in claim 3 or 4, wherein said cooled groups of cards in a sandwich (64, 65) comprise cooled groups of computational accelerating cards in a sandwich (64) and/or cooled groups of central processing/network cards in a sandwich (65) respectively comprising one or more liquid cooling devices (60) coupled with respective one or more computational accelerating cards (44) and/or central processing card (46) and network card (48) disposed on the base plate (42) of the calculation node (40).

6. Architecture as in claim 3, 4 or 5, wherein the base plate (42) of each calculation node (40) is configured to allow at least a connection for electric power by the electric power device (74), a communication inside the calculation node (40) by means of an internal communication network (95) and a network communication of the calculation node (40) toward the outside.

7. Architecture as in claim 3, 4, 5 or 6, wherein each cooled group of cards in a sandwich (64, 65) is associated to heat dispersion devices with plates (67) cooperating with respective liquid cooling devices (60), said central processing card (46), network card (48) and one or more computational accelerating cards (44).

8. Architecture as in any claim hereinbefore, wherein each electronic calculation module (12) comprises a single delivery collector (88) of cooling liquid and a single outlet collector (90) of cooling liquid, to which each of said liquid cooling devices (60) of each cooled group of cards in a sandwich (64, 65) pertain.

9. Architecture as in claims 2 and 8, wherein the delivery collector (88) and the outlet collector (90) are provided with a respective main delivery connector (92) and a respective main outlet connector (94), attached on the rear closing wall (36) and achieving hydraulic connectors (56) for a mechanical attachment and hydraulic connection with main hydraulic connectors (24).

10. Architecture as in claim 9, wherein the hydraulic connectors (56) are in a position more protruding from the box-like container (32) with respect to the electric power device (74).

11. Architecture as in any claim hereinbefore, wherein said electronic calculation modules (12) inserted in said containing rack (14) are autonomously connected both electrically and hydraulically to respective electric power supplies and cooling liquid supplies.

12. Architecture as in any claim hereinbefore, wherein each cooling plate device (80) is formed by two adjacent cooling walls (81).

13. Architecture as in any claim hereinbefore, wherein said electronic calculation module (12) comprises a single delivery collector (88) for the cooling liquid and a single outlet collector (90), configured to serve all the liquid cooling devices (60) of the electronic calculation module (12), the delivery collector (88) and the outlet collector (90) being provided with a respective main delivery connector (92) and a respective main outlet connector (94) connected to main hydraulic connectors (24) of said architecture.

14. Architecture as in claim 13, wherein said main delivery connector (92), said main outlet connector (94) and said hydraulic connectors (24) are quick disconnect zero spillage connectors.

15. Architecture as in claim 13 or 14, wherein the delivery collector (88) is provided with delivery pipes (84) to supply the cooling liquid to each of the cooling pipes (82) of each cooling plate device (80) and the outlet collector (90) is provided with outlet pipes (86), to receive and extract the used cooling liquid from each of the cooling pipes (82) of each cooling plate device (80).

## Patentansprüche

1. Modulare Superrechnerarchitektur, die wenigstens ein Aufnahmegestell (14) umfasst, in welches in einer selektiv entfernbaren Art und Weise eine Mehrzahl an flüssigkeitsgekühlten elektronischen Rechnermodulen (12) eingefügt sind, die miteinander in einem Netzwerk in Verbindung stehen, wobei jedes Rechnermodul (12) umfasst:
- einen Rechnerknoten (40), der mit einer Basisplatte (42) und einer Mehrzahl an elektronischen Karten (44, 46, 48) versehen ist, welche nebeneinander auf der Basisplatte (42) angeordnet sind, wobei die elektronischen Karten (44, 46, 48) wenigstens eine Karte mit Hauptprozessor (46) umfassen und die Basisplatte (42) mit Steckvorrichtungen für Karten bzw. Kartenverbindern (62) zur Verbindung der elektronischen Karten (44, 46, 48) mit der Basisplatte (42) versehen ist;
- eine oder mehrere Flüssigkeitskühlvorrichtungen (60), welche zwischen den elektronischen Karten (44, 46, 48) des Rechnerknotens (40) dazwischenliegend angeordnet sind, um eine oder mehrere Gruppen an Karten in einem Sandwich (64, 65) zu bestimmen, wobei die eine oder die mehreren Flüssigkeitskühlvorrichtungen (60) hinsichtlich der Flüssigkeitskühlvorrichtung (60) der anderen elektronischen Rechnermodulen (12) unabhängig sind und die eine oder die mehreren Flüssigkeitskühlvorrichtungen (60) jeweils eine Kühlplattenvorrichtung (80) mit ihrem eigenen hydraulischen Kühlkreislauf, geformt mittels mehrerer Kühlleitungen (82), aufweisen;
- ein elektrisches Leistungsglied (74);
- einen quaderförmigen Behälter (32), der wenigstens den Rechnerknoten (40) und die eine oder die mehreren Flüssigkeitskühlvorrichtungen (60), welche die eine oder mehreren gekühlten Gruppen an Karten in einem Sandwich (64, 65) bestimmen, sowie das elektrische Leistungsglied (74) einschließt bzw. einhaust und in seinem Inneren schützt, wobei der quaderförmige Behälter (32) einen inneren Hohlraum (38) umgrenzt, der den entsprechenden Rechnerknoten (40) enthält; und zwar so dass jedes elektronische Rechnermodul (12) wenigstens hydraulisch, elektrisch hinsichtlich der Netzwerkkommunikation, und mechanisch unabhängig von den anderen elektronischen Rechnermodulen (12) ist, und heiß eingeführt und/oder entfernt oder in die/aus der Architektur heiß ausgetauscht werden kann.

2. Architektur gemäß Anspruch 1, wobei der Hohlraum (38) mit einer vorderen Einführöffnung (39), einem vorderen Abschlussblech (34) und einer rückwärtigen Abschlusswand (36) versehen ist.

3. Architektur gemäß Anspruch 1 oder 2, wobei die elektronischen Karten (44, 46, 48) wenigstens eine Karte mit Hauptprozessor (46), wenigstens eine Netzwerkarte (48), eine oder mehrere Rechner-Beschleunigungskarten (44) und eine mögliche I/O-Karte (50) umfassen.

4. Architektur gemäß Anspruch 3, wobei jede gekühlte Gruppe an Karten in einem Sandwich (64, 65) eine Mehrzahl an Flüssigkeitskühlvorrichtungen (60) vorsieht, wobei jede jeweils an der Karte mit Hauptprozessor (46), der Netzwerkkarte (48) und einer oder mehrerer Rechner-Beschleunigungskarten (44) angeordnet ist.

5. Architektur gemäß Anspruch 3 oder 4, wobei die gekühlten Gruppen an Karten (64, 65) gekühlte Gruppen an Rechner-Beschleunigungskarten in einem Sandwich (64) und/oder gekühlte Gruppen an Karten mit Hauptprozessor/Netzwerkkarten in einem Sandwich (65) umfassen, wobei diese ein oder mehrere Flüssigkeitskühlvorrichtungen (60) umfassen, die mit jeweils einer oder mehreren Rechner-Beschleunigungskarten (44) und/oder Karten mit Hauptprozessor (46) und einer Netzwerkkarte (48), angeordnet auf der Basisplatte (42) des Rechnerknotens (40), gekoppelt sind.

6. Architektur gemäß Anspruch 3, 4 oder 5, wobei die Basisplatte (42) eines jeden Rechnerknotens (40) derart konfiguriert ist, dass sie wenigsten einen Anschluss für die elektrische Leistung durch das elektrische Leistungsglied (74), eine Übertragung innerhalb des Rechnerknotens (40) durch das innere Übertragungsnetzwerk (95) und eine Netzwerkübertragung des Rechnerknotens (40) nach außen hin ermöglicht.

7. Architektur gemäß Anspruch 3, 4, 5 oder 6, wobei jede gekühlte Gruppe an Karten in einem Sandwich (64, 65) an Wärmeverteilungsvorrichtungen mit Platten (67), die mit den entsprechenden Flüssigkeitskühlvorrichtungen (60) zusammenwirken, der Karte mit Hauptprozessor (46), der Netzwerkkarte (48) und einer oder mehrerer Rechner-Beschleunigungskarten (44) verbunden ist.

8. Architektur gemäß einem der vorangehenden Ansprüche, wobei jedes elektronische Rechnermodul (12) einen einzelnen Zuführsammler (88) für Kühlflüssigkeit und einen einzelnen Auslasssammler (90) für Kühlflüssigkeit umfasst, zugehörig zu jeder der Flüssigkeitskühlvorrichtungen (60) der jeweiligen gekühlten Gruppen an Karten in einem Sandwich (64, 65).

9. Architektur gemäß Anspruch 2 und 8, wobei der Zuführsammler (88) und der Auslasssammler (90) mit einem entsprechenden Hauptzuführanschlussteil (92) und einem entsprechenden Hauptauslassanschlussteil (94) versehen sind, die an der rückwärtigen Abschlusswand (36) angebracht sind und als hydraulische Anschlussteile (56) für eine mechanische Anbringung und eine hydraulische Verbindung mit einem hydraulischen Hauptanschlussteil (24) dienen.

10. Architektur gemäß Anspruch 9, wobei die hydraulischen Anschlussteile (56) hinsichtlich des elektrischen Leistungsglieds (74) in einer aus dem quaderförmigen Behälter (32) weiter hervorragenden Position sind.

11. Architektur gemäß einem der vorangehenden Ansprüche, wobei die in dem Aufnahmegestell (14) eingeführten elektronischen Rechnermodule (12) sowohl elektrisch als auch hydraulisch an die entsprechenden elektrischen Leistungsversorgung und Kühlflüssigkeitsversorgung unabhängig angebunden sind.

12. Architektur gemäß einem der vorangehenden Ansprüche, wobei jede Kühlplattenvorrichtung (80) aus zwei benachbarten Kühlwänden (81) ausgebildet ist.

13. Architektur gemäß einem der vorangehenden Ansprüche, wobei das elektronische Rechnermodul (12) einen einzelnen Zuführsammler (88) und einen einzelnen Auslasssammler (90) umfasst, welche derart konfiguriert sind, dass sie alle Flüssigkeitskühlvorrichtungen (60) des elektronischen Rechnermoduls (12) versorgen, wobei der Zuführsammler (88) und der Auslasssammler (90) mit einem entsprechenden Hauptzuführanschlussteil (92) und einem entsprechenden Hauptauslassanschlussteil (94), verbunden mit dem hydraulischen Hauptanschlussteil (24) der Architektur, versehen sind.

14. Architektur gemäß Anspruch 13, wobei das Hauptzuführanschlussteil (92), das Hauptauslassanschlussteil (94) und die hydraulischen Anschlussteile (24) Leckagefreie Schnellkupplungen sind.

15. Architektur gemäß Anspruch 13 oder 14, wobei der Zuführsammler (88) mit Zuführleitungen (84) versehen ist, um die Kühlflüssigkeit zu jeder der Kühlleitungen (82) einer jeden Kühlplattenvorrichtung (80) zuzuführen, und der Auslasssammler (90) mit Auslassleitungen (86) versehen ist, um die verwendete Kühlflüssigkeit von jeder der Kühlleitungen (82) einer jeden Kühlplattenvorrichtung (80) aufzunehmen und aufzufangen.

## Revendications

1. Architecture de super-calcul modulaire comprenant au moins un bâti de confinement (14) dans lequel est insérée, de manière sélectivement amovible, une pluralité de modules de calcul électroniques refroidis par liquide (12) communiquant entre eux dans un réseau, dans lequel chaque module de calcul électronique (12) comprend :
- un noeud de calcul (40) muni d'une plaque de base (42) et d'une pluralité de cartes électroniques (44, 46, 48) disposées conditionnées côte à côte sur ladite plaque de base (42), lesdites cartes électroniques (44, 46, 48) comprenant au moins une carte de traitement centrale (46), la plaque de base (42) étant munie de connecteurs de carte (62) pour connecter les cartes électroniques (44, 46, 48) à la plaque de base (42) ;
- un ou plusieurs dispositifs de refroidissement liquide (60) disposés de manière intermédiaire entre lesdites cartes électroniques (44, 46, 48) du noeud de calcul (40) pour définir un ou plusieurs groupes refroidis de cartes dans un sandwich (64, 65), lesdits un ou plusieurs dispositifs de refroidissement liquide (60) étant autonomes par rapport aux dispositifs de refroidissement liquide (60) des autres modules de calcul électroniques (12), lesdits un ou plusieurs dispositifs de refroidissement liquide (60) comprenant chacun un dispositif de plaque de refroidissement (80) ayant son propre circuit de refroidissement hydraulique formé par une pluralité de tuyaux de refroidissement (82) ;
- un dispositif d'alimentation électrique (74) ;
- un conteneur en forme de boîte (32) qui entoure et protège à l'intérieur de celui-ci au moins le noeud de calcul (40) et les un ou plusieurs dispositifs de refroidissement liquide (60) définissant lesdits un ou plusieurs groupes de cartes refroidis dans un sandwich (64, 65), et le dispositif d'alimentation électrique (74), ledit conteneur en forme de boîte (32) délimitant une chambre de confinement interne (38) qui contient le noeud de calcul respectif (40) ;
de sorte que chaque module de calcul électronique (12) est au moins hydrauliquement, électriquement en termes de communication réseau, et mécaniquement indépendant des autres modules de calcul électroniques (12), et peut être inséré et/ou retiré chaud ou substitué chaud dans/depuis ladite architecture.

2. Architecture selon la revendication 1, dans laquelle ladite chambre de confinement (38) est prévue avec une ouverture d'insertion avant (39), un panneau de fermeture avant (34) et une paroi de fermeture arrière (36).

3. Architecture selon la revendication 1 ou 2, dans laquelle lesdites cartes électroniques (44, 46, 48) comprennent au moins une carte de traitement centrale (46), au moins une carte de réseau (48), une ou plusieurs cartes d'accélération de calcul (44) et une carte I/O possible (50).

4. Architecture selon la revendication 3, dans laquelle chaque groupe de cartes refroidi dans un sandwich (64, 65) fournit une pluralité de dispositifs de refroidissement liquide (60), disposés chacun respectivement au niveau de chacune de ladite carte de traitement centrale (46), ladite carte de réseau (48), et lesdites une ou plusieurs cartes d'accélération de calcul (44).

5. Architecture selon la revendication 3 ou 4, dans laquelle lesdits groupes de cartes refroidis dans un sandwich (64, 65) comprennent des groupes refroidis de cartes d'accélération de calcul dans un sandwich (64) et/ou des groupes refroidis de cartes de traitement/réseau central dans un sandwich (65) comprenant respectivement un ou plusieurs dispositifs de refroidissement liquide (60) couplés respectivement à une ou plusieurs cartes d'accélération de calcul (44) et/ou une carte de traitement central (46) et une carte de réseau (48) disposées sur la plaque de base (42) du noeud de calcul (40).

6. Architecture selon la revendication 3, 4 ou 5, dans laquelle la plaque de base (42) de chaque noeud de calcul (40) est configurée pour permettre au moins une connexion pour l'énergie électrique par le dispositif d'alimentation électrique (74), une communication à l'intérieur du noeud de calcul (40) au moyen d'un réseau de communication interne (95) et une communication de réseau du noeud de calcul (40) vers l'extérieur.

7. Architecture selon la revendication 3, 4, 5 ou 6, dans laquelle chaque groupe de cartes refroidi dans un sandwich (64, 65) est associé à des dispositifs de dispersion de chaleur avec des plaques (67) coopérant avec des dispositifs de refroidissement liquide respectifs (60), ladite carte de traitement centrale (46), ladite carte de réseau (48) et lesdites une ou plusieurs cartes d'accélération de calcul (44).

8. Architecture selon l'une quelconque des revendications précédentes, dans laquelle chaque module de calcul électronique (12) comprend un unique collecteur de distribution (88) de liquide de refroidissement et un unique collecteur de sortie (90) de liquide de refroidissement, auquel chacun desdits dispositifs de refroidissement liquide (60) de chaque groupe de cartes refroidi dans un sandwich (64, 65) est lié.

9. Architecture selon les revendications 2 et 8, dans laquelle le collecteur de distribution (88) et le collecteur de sortie (90) sont pourvus d'un connecteur de distribution principal respectif (92) et d'un connecteur de sortie principal respectif (94), fixés sur la paroi de fermeture arrière (36) et réalisant des connecteurs hydrauliques (56) pour une fixation mécanique et une connexion hydraulique avec des connecteurs hydrauliques principaux (24).

10. Architecture selon la revendication 9, dans laquelle les connecteurs hydrauliques (56) sont dans une position plus saillante depuis le conteneur en forme de boîte (32) par rapport au dispositif d'alimentation électrique (74).

11. Architecture selon l'une quelconque des revendications précédentes, dans laquelle lesdits modules de calcul électroniques (12) insérés dans ledit bâti de confinement (14) sont connectés de manière autonome à la fois électriquement et hydrauliquement aux alimentations électriques et aux alimentations en liquide de refroidissement respectives.

12. Architecture selon l'une quelconque des revendications précédentes, dans laquelle chaque dispositif de plaque de refroidissement (80) est formé par deux parois de refroidissement adjacentes (81).

13. Architecture selon l'une quelconque des revendications précédentes, dans laquelle ledit module de calcul électronique (12) comprend un unique collecteur de distribution (88) pour le liquide de refroidissement et un unique collecteur de sortie (90), configurés pour desservir tous les dispositifs de refroidissement liquide (60) du module de calcul électronique (12), le collecteur de distribution (88) et le collecteur de sortie (90) étant pourvus d'un connecteur de distribution principal respectif (92) et d'un connecteur de sortie principal respectif (94) connectés aux connecteurs hydrauliques principaux (24) de ladite architecture.

14. Architecture selon la revendication 13, dans laquelle ledit connecteur de distribution principal (92), ledit connecteur de sortie principal (94) et lesdits connecteurs hydrauliques (24) sont des connecteurs sans déversement à déconnexion rapide.

15. Architecture selon la revendication 13 ou 14, dans laquelle le collecteur de distribution (88) est muni de tuyaux de distribution (84) pour fournir le liquide de refroidissement à chacun des tuyaux de refroidissement (82) de chaque dispositif de plaque de refroidissement (80), et le collecteur de sortie (90) est muni de tuyaux de sortie (86), pour recevoir et extraire le liquide de refroidissement usagé depuis chacun des tuyaux de refroidissement (82) de chaque dispositif de plaque de refroidissement (80).
